**Europäisches Patentamt**

**European Patent Office**

**Office européen des brevets**

(19)

(11) Numéro de publication : **0 182 679**
**B1**

(12)

# FASCICULE DE BREVET EUROPÉEN

(45) Date de publication du fascicule du brevet :
15.03.89

(21) Numéro de dépôt : 85401966.8

(22) Date de dépôt : 08.10.85

(51) Int. Cl.⁴ : **H 04 N   3/15, H 01 L 27/14**

(54) **Dispositif photosensible à transfert de ligne muni d'amplificateurs de contre-réaction.**

(30) Priorité : 09.10.84 FR 8415493

(43) Date de publication de la demande :
28.05.86 Bulletin 86/22

(45) Mention de la délivrance du brevet :
15.03.89 Bulletin 89/11

(84) Etats contractants désignés :
DE GB NL

(56) Documents cités :
FR–A– 2 524 751
FR–A– 2 538 200
PATENTS ABSTRACTS OF JAPAN, vol. 8, no. 226 (E-272) [1663], 17 octobre 1984, page 85 E 272; & JP - A - 59 107 567
IEEE JOURNAL OF SOLID-STATE CIRCUITS, vol. SC-12, no. 3, juin 1977, pages 232-237, IEEE, New York, US; P.G.A. JESPERS et al.: "A fast sample and hold charge-sensing circuit for photodiode arrays"

(73) Titulaire : **THOMSON-CSF**
**173, Boulevard Haussmann**
**F-75379 Paris Cédex 08 (FR)**

(72) Inventeur : **Berger, Jean-Luc**
**THOMSON-CSF SCPI 173, bld Haussmann**
**F-75379 Paris Cedex 08 (FR)**
Inventeur : **Brissot, Louis**
**THOMSON-CSF SCPI 173, bld Haussmann**
**F-75379 Paris Cedex 08 (FR)**
Inventeur : **Cazaux, Yvon**
**THOMSON-CSF SCPI 173, bld Haussmann**
**F-75379 Paris Cedex 08 (FR)**

(74) Mandataire : **Mayeux, Michèle et al**
**THOMSON-CSF SCPI 19, avenue de Messine**
**F-75008 Paris (FR)**

**Description**

La présente invention concerne un dispositif photosensible à transfert de ligne muni d'amplificateurs de contre-réaction.

Les dispositifs photosensibles à transfert de ligne sont bien connus de l'art antérieur. On se référera, par exemple, aux demandes de brevet français FR-A-2 504 334 et FR-A-2 538 200 déposées au nom de Thomson-CSF.

On rappelle que ces dispositifs comportent généralement :

— une zone photosensible de M lignes de N points photosensibles sur laquelle l'image à lire est projetée et transformée en charges électriques, dites charges-signal ;

— un organe d'interface de M points, dit mémoire de ligne, connecté par l'intermédiaire de colonnes conductrices aux points photosensibles des différentes lignes et qui reçoit, dans un mode de fonctionnement préféré, successivement, les charges-parasites se trouvant sur les colonnes avant l'arrivée des charges-signal et les charges-signal stockées par chaque ligne ;

— un registre à décalages à transfert de charge qui reçoit les charges-signal en provenance de la mémoire et délivre en série le signal électrique d'analyse de l'image ;

— un drain d'évacuation des charges-parasites en provenance de la mémoire.

La demande de brevet français FR-A-2 524 751 concerne des dispositifs photosensibles à transfert de ligne munis d'amplificateurs de contre-réaction. L'entrée de ces amplificateurs est reliée à une colonne conductrice et à une diode dite diode d'entrée de la mémoire de ligne et leur sortie est reliée à une grille de transfert de la mémoire, adjacente à l'une des diodes d'entrée.

Les amplificateurs de contre-réaction présentent l'avantage de diviser la capacité apparente C des colonnes conductrices par G + 1, où G est le gain des amplificateurs, qui est généralement de l'ordre de 50.

En conséquence, le transfert des charges des colonnes vers la mémoire se fait plus rapidement et l'efficacité de transfert, pour un temps de transfert donné, est améliorée. Le bruit temporel dû au canal situé sous chaque grille de la mémoire reliée à un amplificateur est réduit car il est proportionnel à $\sqrt{C}$.

Un inconvénient important des amplificateurs de contre-réaction, et qui sera démontré par la Demanderesse dans la description détaillée des figures, est qu'il n'est pas possible, si l'on veut obtenir un fonctionnement satisfaisant, de les relier à une grille de la mémoire ayant un canal enterré, et pour laquelle le transfert des charges s'effectue en volume. On est donc obligé d'utiliser des grilles, et donc une mémoire, pour lesquelles le transfert des charges s'effectue en surface.

On va rappeler succinctement ici les avantages qu'il y a à utiliser une mémoire où le transfert des charges s'effectue en volume. Pour obtenir une efficacité de transfert maximum, on utilise généralement un registre de lecture à canal enterré. L'utilisation d'une mémoire où le transfert des charges s'effectue en volume permet un passage bi-latéral des charges entre la mémoire et le registre de lecture, ce qui est particulièrement avantageux dans le cas d'un fonctionnement avec double charge d'entraînement comme cela a été décrit dans la demande de brevet FR-A-2 538 200. Dans le cas où le transfert s'effectue en surface dans la mémoire, il n'est pas possible de transférer les charges du registre vers la mémoire, car, pour une même tension appliquée sur les grilles, les potentiels de surface sont à un niveau plus haut dans le cas du transfert en volume que dans le cas du transfert en surface. L'utilisation d'une mémoire où le transfert des charges s'effectue en volume permet aussi l'amélioration de l'efficacité de transfert vertical. Cette efficacité est inversement proportionnelle à la capacité des colonnes, qui est diminuée du fait du transfert en volume. En effet, les colonnes sont essentiellement constituées par des diodes de lecture reliées entre elles. Ces diodes sont polarisées en inverse. Du fait du transfert en volume, ces diodes reçoivent une tension de polarisation plus importante, pour des tensions appliquées identiques sur les éléments de la mémoire de ligne, et la capacité de ces diodes est diminuée. D'autre part, le bruit lors des transferts entre les colonnes et la mémoire de ligne a deux origines, à savoir un bruit thermique qui est proportionnel à la racine carrée de la capacité colonne et un bruit proportionnel aux pièges de surface et de volume sous la grille de transfert entre les colonnes et la mémoire de ligne. Le passage au transfert en volume réduit ces deux composantes en réduisant la capacité des colonnes, comme cela a été mentionné ci-dessus et en supprimant les pièges d'interfaces.

Un autre inconvénient des amplificateurs de contre-réaction est qu'ils introduisent du bruit, plus particulièrement en basse fréquence. Ce bruit peut dans certains cas être aussi important que le bruit de lecture introduit par le canal de la grille de transfert entre les colonnes et la mémoire.

La présente invention permet de résoudre les problèmes énoncés précédemment. Elle permet, en particulier, l'utilisation d'une grille de transfert entre les colonnes et la mémoire et d'une mémoire, où le transfert des charges s'effectue en volume. Dans un mode de réalisation particulier, la présente invention permet aussi la diminution du bruit basse fréquence dû aux amplificateurs de contre-réaction.

La présente invention concerne un dispositif photosensible à transfert de ligne, comportant une zone photosensible de M lignes de N points photosensibles, les points photosensibles des différentes lignes étant reliés en parallèle par des colonnes conductrices à des diodes appartenant à une mémoire de ligne, qui assure au moins le transfert vers un registre de lecture des charges-signal d'une même ligne, ce dispositif photosensible comportant des amplificateurs de contre-réaction dont l'entrée est reliée à une colonne et à une diode de la mémoire et dont la sortie est reliée à une grille de transfert de la mémoire, adjacente à l'une des diodes, caractérisé en ce que :

— la mémoire de ligne et le registre de lecture sont réalisés de façon telle que le transfert des charges s'y effectue en volume ;

— des moyens permettent d'ajuster la tension de seuil de chaque amplificateur pour que le point de fonctionnement de l'ensemble constitué par chaque amplificateur, la diode et la grille de la mémoire auxquelles il est relié, soit situé dans la zone à gain élevé de la caractéristique de transfert de l'amplificateur.

On décrira dans ce qui suit divers modes de réalisation des moyens permettant d'ajuster la tension de seuil de chaque amplificateur.

Pour diminuer le bruit basse fréquence dû aux amplificateurs, la présente invention propose d'effectuer une double lecture successivement des charges parasites se trouvant sur les colonnes conductrices et des charges-signal, avec deux charges d'entraînement seulement. On montrera dans la description détaillée des figures que cette double lecture permet de filtrer le bruit basse fréquence dû aux amplificateurs.

D'autres objets, caractéristiques et résultats de l'invention ressortiront de la description suivante, donnée à titre d'exemple non limitatif et illustrée par les figures annexées qui représentent :

— la figure 1, le schéma d'un dispositif photosensible à transfert de ligne muni d'amplificateurs de contre-réaction, tel que connu dans l'art antérieur ;

— la figure 2, un mode de réalisation des amplificateurs reliés à la mémoire de ligne ;

— les figures 3 et 5, des courbes illustrant le fonctionnement respectivement d'un dispositif selon l'art antérieur et selon l'invention ;

— les figures 4, 6 et 7, des schémas illustrant divers moyens permettant d'augmenter la tension de seuil des amplificateurs ;

— les figures 8, 9 et 10a à g, des courbes et des schémas illustrant le filtrage basse fréquence réalisé ;

— la figure 11, le schéma d'un mode de réalisation d'un dispositf à transfert de ligne muni d'amplificateurs de contre-réaction et effectuant une double lecture.

Sur les différentes figures, les mêmes repères désignent les mêmes éléments, mais, pour des raisons de clarté, les cotes et proportions de divers éléments ne sont pas respectées.

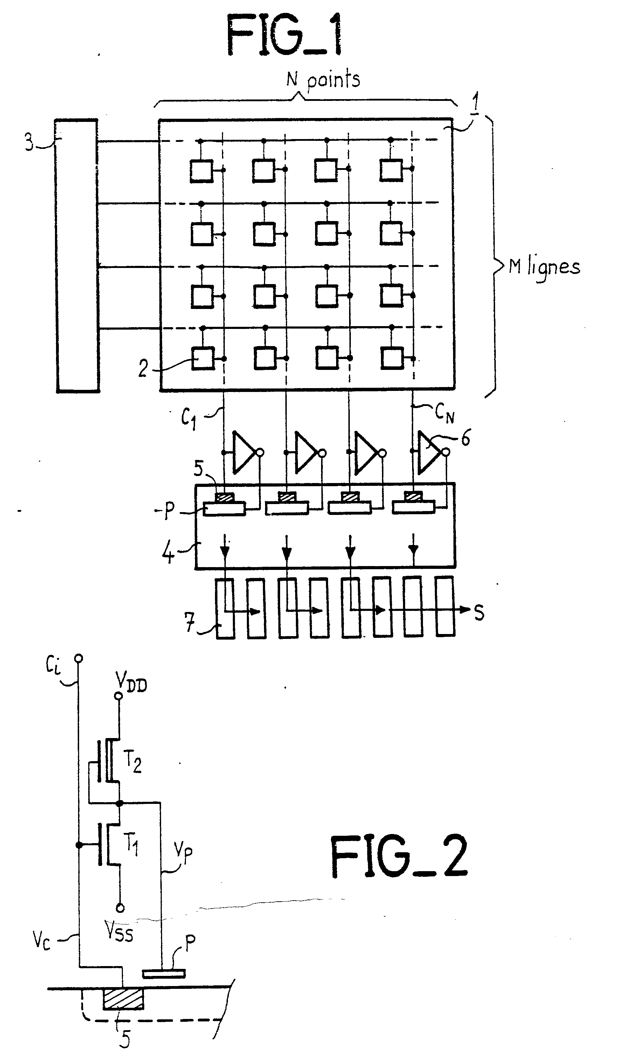

La figure 1 représente le schéma d'un dispositif photosensible à transfert de ligne muni d'amplificateurs de contre-réaction selon l'art connu précité.

Sur la figure 1, on a représenté de façon schématique la zone photosensible 1 avec M lignes de N points photosensibles 2. Un registre à décalages 3 permet d'adresser successivement chaque ligne. Des colonnes conductrices $C_1$ à $C_N$ relient en parallèle les points photosensibles d'une même colonne à une mémoire de ligne 4. On n'a représenté que les diodes d'entrée 5 de la mémoire qui sont reliées aux colonnes, et les grilles de transfert P qui leur sont adjacentes.

Des amplificateurs de contre-réaction 6 ont leur entrée reliée à une colonne conductrice et à une diode d'entrée 5 de la mémoire et leur sortie reliée à une grille P de transfert entre les colonnes et la mémoire.

Les charges-signal en provenance de la mémoire sont transférées dans un registre à décalages à transfert de charge 7 dit registre de lecture qui délivre en série le signal électrique S d'analyse de l'image. Les amplificateurs 6 sont réalisés de façon courante par deux transistors MOS montés en inverseur.

La figure 2 montre le schéma d'un tel amplificateur constitué d'un transistor MOS à enrichissement $T_1$ en série avec un transistor MOS à déplétion $T_2$ et qui est relié à la mémoire de ligne. La grille de $T_1$ constitue l'entrée de l'amplificateur qui est reliée à une diode d'entrée 5 de la mémoire et à une colonne conductrice $C_i$. L'une des autres électrodes du transistor $T_1$ est reliée à une tension de polarisation constante $V_{SS}$ et une dernière électrode du transistor $T_1$ constitue la sortie de l'amplificateur, qui se trouve reliée à une électrode du transistor $T_2$ et à une grille P de transfert des charges des colonnes vers la mémoire.

La grille du transistor $T_2$ est reliée à la sortie de l'amplificateur et une dernière électrode du transistor $T_2$ est reliée à une tension de polarisation constante $V_{DD}$.

Dans le cas où l'on utilise un transistor $T_2$ à enrichissement sa grille est reliée à la tension de polarisation constante $V_{DD}$.

Dans l'art connu précité, il n'est pas précisé si la mémoire de ligne, et donc les grilles P de transfert des charges entre les colonnes et la mémoire, opèrent un transfert des charges en surface ou en volume, mais seulement que « les tensions de la source et du drain doivent être choisies de manière que l'inverseur fonctionne dans une zone à gain élevé ».

La Demanderesse va démontrer dans ce qui suit que ce dispositif ne peut fonctionner de façon satisfaisante qu'avec une mémoire de ligne, et donc des grilles P de transfert des charges de la colonne vers la mémoire, réalisant un transfert des charges en surface.

Le point d'équilibre du montage de la figure 2 s'obtient par l'intersection de la caractéristique du transfert $V_P$, $V_C$ de l'amplificateur, où $V_P$ est la tension de sortie de l'amplificateur et $V_C$ sa tension d'entrée avec la courbe représentant le potentiel $\varnothing_S$ du canal sous la grille P en fonction de la tension $V_P$ appliquée à cette grille.

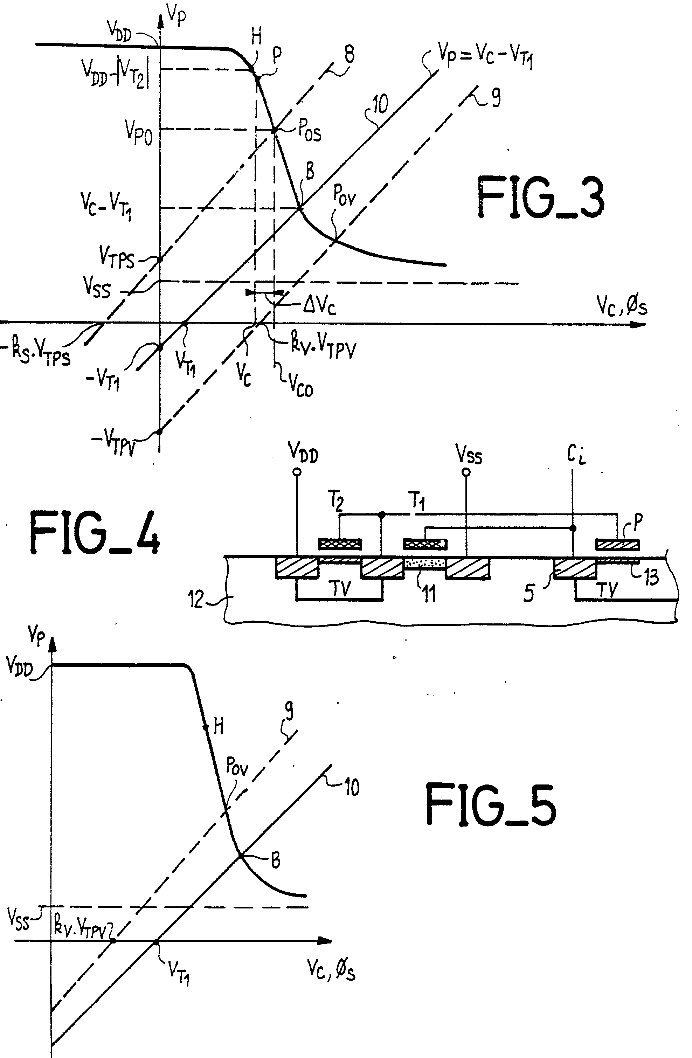

Sur la figure 3, on a représenté dans le même plan, en trait plein la caractéristique de l'amplificateur et en pointillés la courbe $(\varnothing_S, V_P)$ 8 pour la grille P dans le cas d'un transfert en surface et la courbe $(\varnothing_S, V_P)$ 9 pour la grille P dans le cas d'un transfert en volume.

Les deux courbes 8 et 9 de la grille P sont sensiblement des droites de pentes $k_S$ et $k_V$, positives et proches de l'unité dans le cas des technologies usuelles. On appelle $P_{OS}$ et $P_{OV}$ les points d'intersection des droites 8 et 9 avec la caractéristique de transfert de l'amplificateur.

Ces droites 8 et 9 coupent l'axe $V_P$ aux points d'ordonnées $V_{TPS}$ et $-V_{TPV}$ et l'axe $V_C$, $\varnothing_S$ aux points d'abscisses $-k_S \cdot V_{TPS}$ et $k_V \cdot V_{TPV}$.

On a porté sur la caractéristique de transfert de l'amplificateur les points H et B qui délimitent la zone à gain élevé de la caractéristique de transfert de l'amplificateur, qui est celle pour laquelle les deux transistors $T_1$ et $T_2$ sont polarisés en saturation.

Le point H est celui à partir duquel le transistor $T_2$ rentre en saturation ; il a pour ordonnée $V_{DD} - |V_{T2}|$, où $V_{T2}$ est la tension de seuil du transistor $T_2$.

Le point B est celui à partir duquel le transistor $T_1$ fonctionne en triode. Il a pour ordonnée $V_C - V_{T1}$, où $V_{T1}$ est la tension de seuil du transistor $T_1$.

On a représenté sur la figure 3 la droite 10 d'équation $V_P = V_C - V_{T1}$ qui coupe l'axe $V_C$, $\varnothing_S$ à l'abscisse $V_{T1}$ et l'axe $V_P$ à l'ordonnée $-V_{T1}$.

Le point $P_{OS}$ est toujours situé au-dessus du point B car l'inégalité suivante est toujours vérifiée, $V_{T1} > -k_S \cdot V_{TPS}$, $V_{T1}$, $k_S$ et $V_{TPS}$ étant positifs et les droites 8 et 10 sensiblement parallèles. Pour un bon fonctionnement, il faut aussi que le point $P_{OS}$ ne soit pas trop près du point H car lorsqu'une charge arrive sur une colonne pour être transférée le point de fonctionnement $P_{OS}$ d'abscisse $V_{CO}$ passe en un point P d'abscisse $V_C = V_{CO} - V_c$ plus proche de H. Le réglage des tensions $V_{DD}$ et $V_{SS}$ permet d'éloigner le point $P_{OS}$ du point H. Sur la figure 3, on a indiqué que l'intersection de la caractéristique de l'amplificateur avec l'axe $V_p$ se fait au point d'ordonnée $V_{DD}$ et que la caractéristique de l'amplificateur tend vers une asymptote horizontale d'ordonnée proche de $V_{SS}$.

On peut régler la tension $V_{SS}$ et ensuite la tension $V_{DD}$ pour que la condition suivante soit vérifiée : $V_{DD} - V_{T2} > V_{PO} + G \cdot \Delta V_C$ où $V_{PO}$ est l'ordonnée du point $P_{OS}$.

En conclusion avec une grille P en surface, l'amplificateur fonctionne dans une zone à gain élevé.

Le point $P_{OV}$ est toujours situé en dessous du point B car l'inégalité suivante est toujours vérifiée : $V_{T1} < K_V \cdot V_{TPV}$ et les droites 9 et 10 sont sensiblement parallèles. En effet, dans les technologies usuelles, $V_{T1}$ varie entre 0,5 et 1,5 V et $V_{TPV}$ entre 3 et 10 V, avec une pente $K_V$ proche de l'unité.

La figure 3 démontre clairement que la droite 9 étant positionnée en-dessous de la droite 10 il n'est pas possible de faire passer le point $P_{OV}$ entre les points H et B, même en agissant sur les tensions de polarisation $V_{DD}$ et $V_{SS}$.

En conséquence, puisque dans le brevet précité il est indiqué qu'il faut agir sur les tensions de polarisation $V_{DD}$ et $V_{SS}$ pour que l'inverseur fonctionne dans une zone à gain élevé, cela signifie qu'il faut utiliser des grilles P et donc une mémoire de ligne où le transfert des charges s'effectue en surface avec tous les inconvénients que cela comporte.

Il n'est pas possible d'obtenir un fonctionnement satisfaisant avec des grilles P, et donc une mémoire de ligne, où le transfert de charges s'effectue en volume, si l'on ne dispose que des tensions de polarisation $V_{DD}$ et $V_{SS}$ pour régler le point de fonctionnement.

Selon l'invention, on obtient un fonctionnement satisfaisant en utilisant des grilles P et une mémoire de ligne à canal enterré, où le transfert des charges s'effectue en volume, en déplaçant la droite 10 d'équation $V_P = V_C - V_{T1}$ de façon que la droite 9 soit située au-dessus de la droite 10. Ainsi le point de fonctionnement $P_{OV}$ est situé entre les points H et B. Sur la figure 5, on a représenté la nouvelle disposition des droites 9 et 10 et des points $P_{OV}$ et B. Selon l'invention, on utilise des moyens permettant d'ajuster la tension de seuil $V_{T1}$ de chaque amplificateur pour que l'inégalité suivante soit vérifiée : $V_{T1} > k_V \cdot V_{TPV}$. Cette tension de seuil de l'amplificateur est celle pour laquelle il commence à conduire. Dans le cas d'un mode de réalisation de l'amplificateur tel que celui représenté sur la figure 2, la tension de seuil de l'amplificateur est celle du transistor MOS $T_1$.

On a représenté sur la figure 4 un mode de réalisation des moyens permettant d'ajuster la tension $V_{T1}$.

On augmente la tension $V_{T1}$ en réalisant un enrichissement 11 dans son propre type d'impuretés de la zone du substrat 12 située sous la grille du transistor $T_1$ de façon à avoir : $V_{T1} > K_V \cdot V_{TPV}$.

Sur la figure 4, on voit que la grille P et le transistor $T_2$ sont réalisés sur un canal en volume, noté TV.

On peut, quels que soient les moyens utilisés pour ajuster $V_{T1}$, réaliser sous la grille P une zone 13 d'un type d'impuretés opposé à celui du canal enterré noté TV situé sous cette grille. On diminue ainsi la valeur de $V_{TPV}$ ce qui permet de satisfaire plus facilement l'inégalité : $V_{T1} > K_V \cdot V_{TPV}$.

On réalise généralement de tels dopages sous les grilles de transfert du registre de lecture fonctionnant en volume.

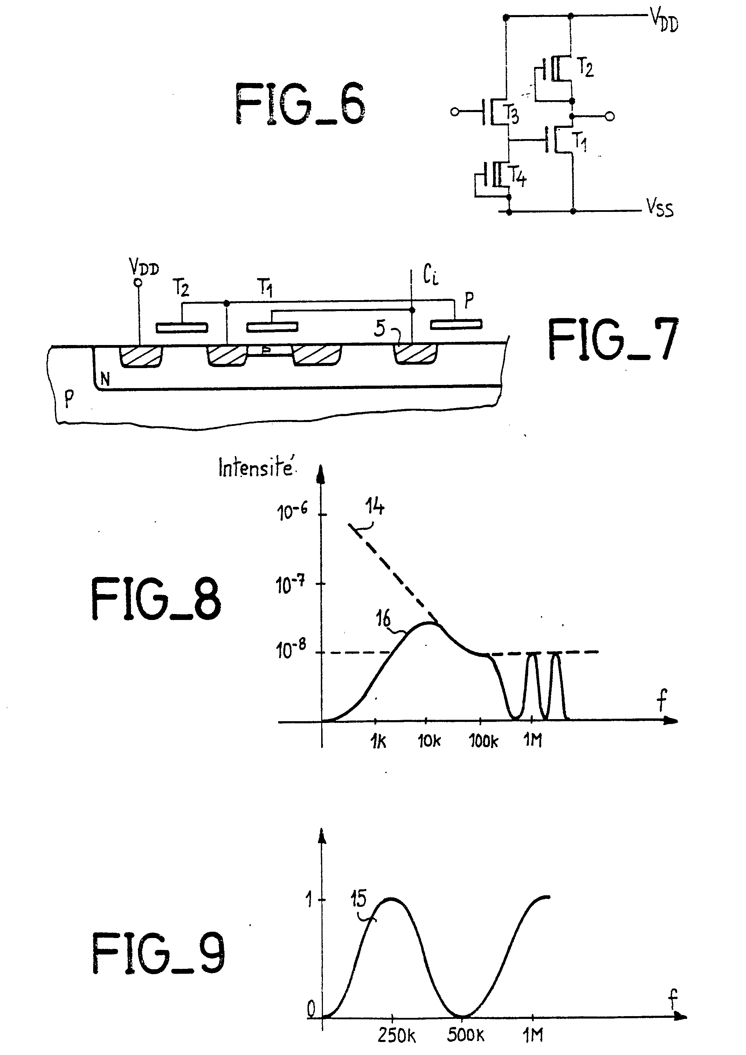

Sur la figure 6, on a représenté un autre mode de réalisation des moyens permettant d'ajuster la tension de seuil de chaque amplificateur.

Sur la figure 6, l'amplificateur est constitué comme sur la figure 1 de deux transistors $T_1$ et $T_2$ mais un troisième et un quatrième transistors MOS $T_3$ et $T_4$, montés en suiveurs, sont intercalés entre chaque diode d'entrée 5 de la mémoire et la grille du transistor $T_1$.

La tension de seuil du dispositif de la figure 6 est égale à $V_{T3} + V_{T1}$, où $V_{T3}$ est la tension de seuil du transistor MOS $T_3$ dont la grille est reliée à une diode 5 de la mémoire.

Dans le mode de réalisation de la figure 6, on a utilisé des transistors MOS $T_3$ et $T_4$ respectivement à enrichissement et à déplétion.

La grille du transistor $T_3$ est reliée à la diode d'entrée 5 de la mémoire et à une colonne conductrice, les deux autres électrodes de ce transistor sont reliées à la tension $V_{DD}$ et à la grille du transistor $T_1$. Le transistor $T_4$ a sa grille et une électrode reliées à la tension de polarisation $V_{SS}$ et une autre électrode reliée à la grille du transistor $T_1$.

Dans une variante, on peut utiliser un transistor MOS $T_4$ à enrichissement dont la grille est reliée à la grille du transistor MOS $T_1$.

Une autre solution pour ajuster la tension de seuil de chaque amplificateur est représentée sur la figure 7. Elle consiste à utiliser un amplificateur comportant deux transistors montés en inverseur, comme sur la figure 2, mais dans ce cas on utilise un transistor MOS $T_2$ à déplétion à canal N et un transistor MOS $T_1$ à déplétion à canal P, ce qui permet d'augmenter suffisamment la tension de seuil $V_{T1}$ de l'amplificateur. L'utilisation d'un transistor MOS $T_1$ à déplétion permet de diminuer le bruit.

La tension de seuil de l'amplificateur est ajustée dans ce cas par l'intermédiaire de l'implantation de type P située sous la grille du transistor $T_1$.

On peut utiliser simultanément les divers moyens décrits pour ajuster la tension de seuil des amplificateurs.

On peut aussi, en plus, régler le point de fonctionnement en ajustant les tensions de polarisation $V_{DD}$ et $V_{SS}$, mais ce réglage n'est pas à lui seul suffisant pour que le point de fonctionnement $P_{OV}$ soit situé dans la zone à gain élevé de la caractéristique de l'amplificateur.

On a exposé dans l'introduction à la description qu'un inconvénient des amplificateurs de contre-réaction est le bruit qu'ils introduisent essentiellement en basse fréquence.

Ce bruit est dû aux transistors MOS. En basse fréquence, ces transistors ont une réponse spectrale en 1/f dont la fréquence de coupure se situe entre 20 et 100 KHz. En haute fréquence, ces transistors présentent un niveau de bruit beaucoup plus faible et de spectre semblable à celui d'un bruit blanc.

Sur la figure 8, la courbe en pointillés 14 représente la répartition spectrale du bruit de l'amplificateur.

La Demanderesse présente une solution qui permet de réduire le bruit basse fréquence dû aux amplificateurs et qui consiste à effectuer une double lecture.

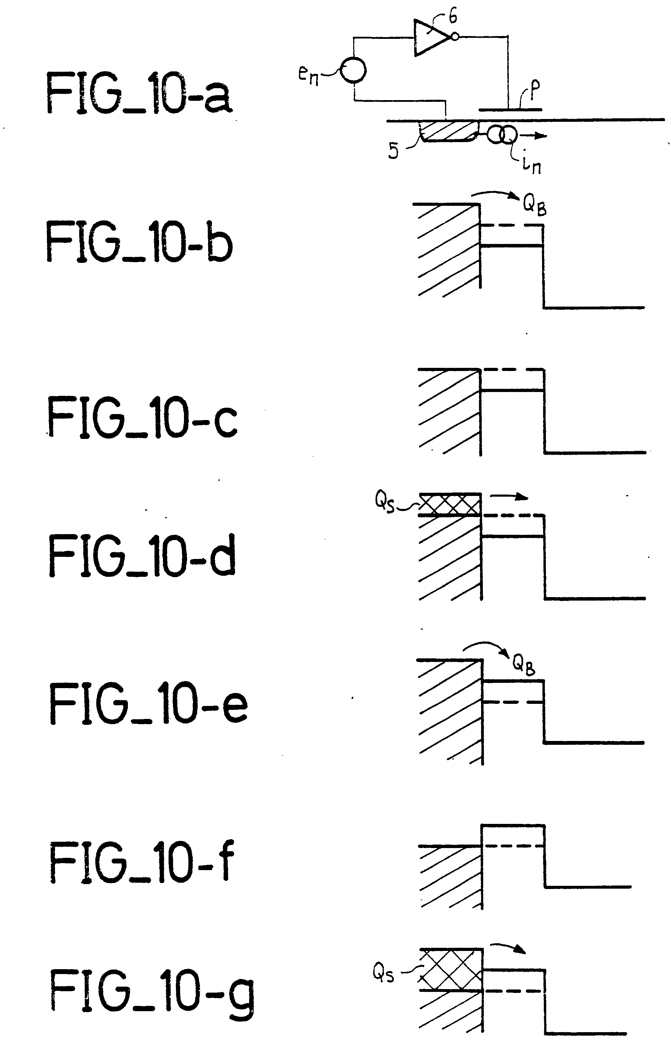

Cette solution va être expliquée en se référant aux figures 10a à f.

Dans la demande de brevet FR-A-2 538 200 déjà citée, on trouve décrit un procédé d'analyse d'un dispositif photosensible à transfert de ligne dans lequel on évacue les charges parasites se trouvant sur les colonnes avant de lire les charges signal. C'est cette double lecture qui est utilisée pour filtrer le bruit basse fréquence dû aux amplificateurs alors que son but premier était l'évacuation des charges parasites.

Sur la figure 10a, on a représenté une diode d'entrée 5 de la mémoire, avec sa grille de transfert P, l'amplificateur 6 qui est relié entre la diode et la mémoire, et les deux sources principales de bruit temporel qui sont la tension de bruit $e_n$ de l'amplificateur et le courant de bruit $i_n$ du canal sous la grille P.

Le courant de bruit $i_n$ donne naissance à un bruit proportionnel à $\sqrt{KTC}$, où K est la constante de Boltzmann, T la température et C la capacité des colonnes qui est divisée par G + 1 grâce à l'amplificateur de contre-réaction.

La tension de bruit de l'amplificateur introduit une fluctuation sur la barrière de potentiel sous la grille G qui conditionne le transfert des charges vers la mémoire.

Selon la répartition spectrale du bruit, cette barrière de potentiel a son niveau qui varie durant le transfert des charges-signal s'il s'agit de composantes haute fréquence ou d'une lecture des charges-signal à la lecture suivante, s'il s'agit de composantes basse fréquence.

La double lecture permet de supprimer les composantes basse fréquence comme on va le montrer.

Sur les figures 10b et 10e, on a représenté en trait plein la barrière de potentiel sous la grille P, lorsqu'il n'y a pas de bruit et en pointillés la barrière de potentiel sous la grille P, en présence de bruit. Le bruit peut produire une augmentation ou une diminution du niveau de la barrière, comme représenté respectivement sur les figures 10b et 10e. La lecture des charges parasites $Q_B$ se trouvant sur les colonnes provoque l'alignement du potentiel existant sous la diode 5 sur le niveau temporaire de la barrière de potentiel, comme cela est représenté sur les figures 10c et 10f.

En conséquence, lorsque les charges-signal $Q_S$ arrivent sur les colonnes elles sont transmises dans leur totalité comme cela est représenté sur les figures 10d et 10g.

Une lecture des charges-signal faite immédiatement après la lecture des charges parasites permet donc de filtrer les composants basses fréquences du bruit, à condition que le niveau de la barrière de potentiel sous la grille P n'ait pas changé entre les deux lectures.

La fonction de transfert d'un tel filtrage s'exprime en fonction de la fréquence f du bruit par la relation : $A = 1 - \cos 2\pi f\tau$, où $\tau$ est l'intervalle de temps entre deux lectures.

Sur la figure 9, la courbe 15 représente la fonction de transfert de l'opération de double lecture.

Sur la figure 8, la courbe en trait plein 16 représente la répartition spectrale du bruit de l'amplificateur avec double lecture qui montre le filtrage basse fréquence réalisé.

Le filtrage du bruit basse fréquence grâce à la double lecture a été vérifié expérimentalement en injectant artificiellement du bruit sur les colonnes.

Dans la demande de brevet FR-A-2 538 200 déjà citée la double lecture des charges nécessite trois charges d'entraînement comme cela est schématisé à la figure 4 de ce brevet. Il faut une charge d'entraînement $Q_O$ de l'ordre de 4 à 5 fois la charge-signal maximum pour transférer les charges des colonnes vers la mémoire. Cette charge $Q_O$ très importante reste stockée sous les capacités $C_1$ de la mémoire et il faut deux charges d'entraînement moins importantes $Q_1$ et $Q_2$ pour transférer les charges signal $Q_S$ et les charges parasites $Q_B$ de la mémoire respectivement vers le registre de lecture et le drain.

Dans le cas d'un dispositif photosensible à transfert de ligne muni d'amplificateurs de contre-réaction, deux charges d'entraînement $Q_1$ et $Q_2$ sont suffisantes. En effet, la capacité apparente des colonnes est divisée par $G + 1$, la charge d'entraînement nécessaire pour un transfert efficace des charges des colonnes vers la mémoire peut être réduite et une charge d'entraînement de l'ordre du dixième de la charge-signal maximum est suffisante.

Une telle charge d'entraînement peut être sans difficulté apportée par un registre à décalages à transfert de charge sans que sa capacité de stockage et ses dimensions soient augmentées pour cela.

En conséquence, dans le dispositif selon l'invention on utilise deux charges d'entraînement $Q_1$ et $Q_2$, de même amplitude que les charges $Q_1$ et $Q_2$ de l'Art Antérieur qui servent à la fois au transfert des charges des colonnes vers la mémoire et de la mémoire vers le registre de lecture ou vers le drain d'évacuation. Ces charges d'entraînement ne sont pas stockées en mémoire mais injectées de préférence par deux registres à décalages à transfert de charge, qui sont le registre de lecture 7 et un registre auxiliaire 14 qui ne sert qu'à l'injection d'une charge d'entraînement.

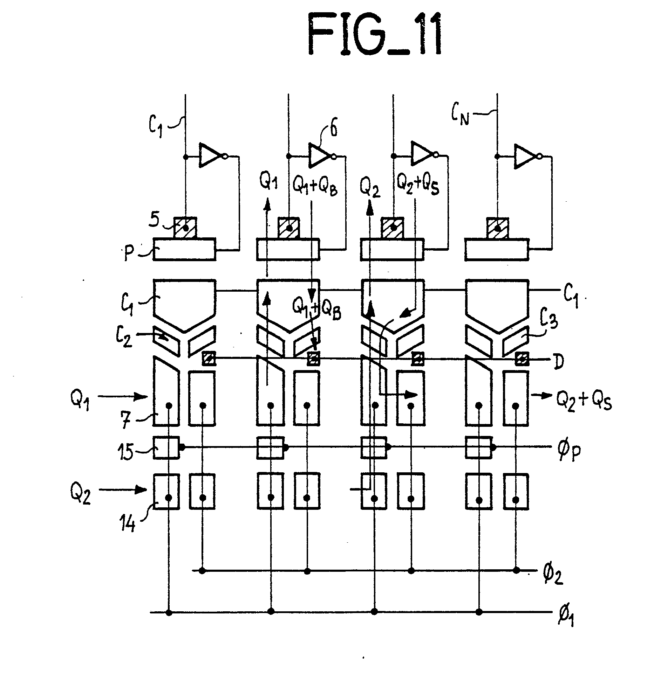

La nouvelle structure du dispositif selon l'invention est représentée sur la figure 11.

La mémoire de ligne ne comporte plus qu'un seul étage avec des grilles intermédiaires $C_1$, qui ne servent plus au stockage des charges d'entraînement $Q_O$ comme dans la demande de brevet FR-A-2 538 200, mais qui servent à aiguiller les charges signal $Q_S$ vers le registre de lecture et les charges parasites $Q_B$ vers un drain. Cet aiguillage se fait par l'intermédiaire de grilles de transfert $C_2$ et $C_3$.

Sur la figure 11, on a indiqué de façon symbolique qu'une charge d'entraînement $Q_1$ est obtenue en injectant en permanence cette quantité de charge dans le registre de lecture 7. Cette charge d'entraînement est transférée dans la mémoire avant l'arrivée des charges à lire.

Il est possible d'obtenir cette charge d'entraînement $Q_1$ d'une autre façon par exemple par injection au niveau des grilles $C_1$ de la mémoire à partir de diodes associées à des grilles d'injection.

En ce qui concerne la charge d'entraînement $Q_2$, elle peut être introduite dans la mémoire à partir du drain d'évacuation. Dans la demande de brevet FR-A-2 538 200, on a exposé ces diverses possibilités pour générer les charges d'entraînement.

La charge d'entraînement $Q_2$ peut aussi être générée à l'aide d'un registre à décalages à transfert de charge auxiliaire, dans lequel on injecte en série cette quantité de charge $Q_2$. Sur la figure 11, on a représenté un tel registre auxiliaire 14, qui est positionné parallèlement au registre de lecture et qui comporte des grilles 15 permettant les transferts des charges d'entraînement $Q_2$ dans le registre de lecture.

Il serait aussi possible de disposer ce registre auxiliaire 14 parallèlement à la série de diodes d'entrée 5 et de transférer les charges $Q_2$ du registre dans les diodes 5.

Sur la figure 11, des flèches symbolisent les différents transferts accompagnant la double lecture. On a représenté sur deux étages successifs du dispositif les transferts permettant l'évacuation des charges parasites et les transferts permettant la lecture des charges signal.

On transfère les charges d'entraînement $Q_1$ du registre de lecture, dans la mémoire puis sous les diodes d'entrée 5 de la mémoire. On transfère ensuite les charges $Q_1 + Q_B$ vers la mémoire puis vers le drain d'évacuation, $Q_B$ étant les charges parasites se trouvant sur les colonnes.

On transfère les charges d'entraînement $Q_2$ à partir du registre auxiliaire, dans le registre de lecture, dans la mémoire puis sous les diodes d'entrée 5 de la mémoire.

Après l'arrivée des charges signal $Q_S$ sur ces diodes, on transfère les charges $Q_2 + Q_S$ dans la mémoire puis dans le registre de lecture.

Tous ces transferts se font pendant le temps de retour ligne. Pendant le temps ligne, les charges signal sont lues et de nouvelles charges d'entraînement sont injectées en série dans les registres.

Pour un fonctionnement optimum du dispositif, on utilise des charges $Q_1$ et $Q_2$ aussi semblables que possible ce qui permet une symétrie parfaite des organes d'injection.

Les charges $Q_1$ et $Q_2$ peuvent aussi bien être utilisées pour transférer les charges-signal que les charges parasites, sauf dans le mode de réalisation de la figure 11 où il faut d'abord utiliser les charges d'entraînement $Q_1$ avant de transférer les charges d'entraînement $Q_2$ dans le registre de lecture, ce qui impose d'utiliser les charges $Q_1$ pour transférer les charges parasites et les charges $Q_2$ pour transférer les charges signal.

Enfin, on utilise un registre auxiliaire 14 où le transfert des charges s'effectue en volume pour avoir une efficacité de transfert optimale surtout dans le sens latéral.

La double lecture permet en plus de la diminution du bruit basse fréquence dû aux amplificateurs l'élimination des charges parasites.

On peut utiliser un dispositif photosensible à transfert de ligne muni d'amplificateurs de contre-réaction avec un dispositif anti-éblouissement au niveau de chaque point photosensible.

Même dans ce cas, l'usage de la double lecture est très intéressant pour diminuer le bruit.

## Revendications

1. Dispositif photosensible à transfert de ligne, comportant une zone photosensible (1) de M lignes de N points photosensibles, les points photosensibles des différentes lignes étant reliés en parallèle par des colonnes conductrices ($C_1...C_N$) à des diodes (5) appartenant à une mémoire de ligne, qui assure au moins le transfert vers un registre de lecture (7) des charges-signal ($Q_S$) d'une même ligne, ce dispositif photosensible comportant des amplificateurs de contre-réaction (6) dont l'entrée est reliée à une colonne et à une diode (5) de la mémoire et dont la sortie est reliée à une grille de transfert (P) de la mémoire, adjacente à l'une des diodes, caractérisé en ce que :

— la mémoire de ligne (4) et le registre de lecture (7) sont réalisés de façon telle que le transfert des charges s'y effectue en volume ;

— des moyens permettent d'ajuster la tension de seuil ($V_{T1}$) de chaque amplificateur (6) pour que le point de fonctionnement ($P_{OV}$) de l'ensemble constitué par chaque amplificateur (6), la diode (5) et la grille (P) de la mémoire (4) auxquelles il est relié, soit situé dans la zone (HB) à gain élevé de la caractéristique de transfert de l'amplificateur.

2. Dispositif selon la revendication 1, caractérisé en ce que chaque amplificateur (6) est constitué par un premier et un deuxième transistors MOS ($T_1$, $T_2$), montés en inverseur.

3. Dispositif selon la revendication 2, caractérisé en ce qu'il comporte un premier transistor MOS ($T_1$) à enrichissement dont la grille constitue l'entrée de l'amplificateur, dont l'une des autres électrodes est reliée à une tension de polarisation constante ($V_{SS}$) et dont la dernière électrode constitue la sortie de l'amplificateur et se trouve reliée à une électrode du deuxième transistor MOS ($T_2$).

4. Dispositif selon la revendication 3, caractérisé en ce qu'il comporte un deuxième transistor MOS ($T_2$) à déplétion dont la grille est reliée à la sortie de l'amplificateur et dont une autre électrode est reliée à une tension de polarisation constante ($V_{DD}$).

5. Dispositif selon la revendication 3, caractérisé en ce qu'il comporte un deuxième transistor MOS ($T_2$) à enrichissement, dont la grille est reliée à l'une de ses électrodes qui reçoit une tension de polarisation constante ($V_{DD}$).

6. Dispositif selon l'une des revendications 2 à 5, caractérisé en ce que les moyens permettant d'ajuster la tension de seuil de chaque amplificateur (6) sont constitués par un enrichissement (11) dans son propre type d'impuretés de la zone du substrat (12) située sous la grille du premier transistor MOS ($T_1$).

7. Dispositif selon l'une des revendications 2 à 6, caractérisé en ce que les moyens permettant d'ajuster la tension de seuil de chaque amplificateur (6) sont constitués par un étage suiveur comportant un troisième et un quatrième transistors MOS ($T_3$, $T_4$), intercalés entre chaque diode (5) de la mémoire (4) et l'entrée d'un amplificateur (6), la tension de seuil de chaque amplificateur étant ajustée par l'intermédiaire de la tension de seuil ($V_{T3}$) du troisième transistor MOS dont la grille est reliée à une diode de la mémoire.

8. Dispositif selon l'une des revendications 2 à 7, caractérisé en ce que les moyens permettant d'ajuster la tension de seuil de chaque amplificateur (6) sont constitués par la réalisation d'un premier transistor MOS ($T_1$) à déplétion de canal P et d'un deuxième transistor MOS ($T_2$) à déplétion de canal N.

9. Dispositif selon l'une des revendications 1 à 8, caractérisé en ce que sous chaque grille de transfert (P) de la mémoire (4), adjacente à une diode d'entrée (5), il existe une zone (13) d'un type d'impuretés opposé à celui du canal enterré (TV) situé sous cette grille.

10. Dispositif selon l'une des revendications 1 à 9, caractérisé en ce que la mémoire de ligne (4) est constituée par une série de grilles de stockage ($C_1$), adjacentes aux grilles de transfert (P) de la mémoire reliées aux amplificateurs (6), chaque grille de stockage ($C_1$) débouchant sur deux grilles de transfert ($C_2$, $C_3$) l'une conduisant vers un drain d'évacuation des charges (D) et l'autre vers le registre de lecture (7).

11. Dispositif selon la revendication 10, caractérisé en ce que le registre de lecture (7) est un registre à décalages à transfert de charge qui est positionné parallèlement à la mémoire de ligne (4) et qui comporte des moyens d'injection dans tous ses étages d'une première charge d'entraînement ($Q_1$).

12. Dispositif selon l'une des revendications 10 ou 11, caractérisé en ce qu'il comporte un registre à décalages à transfert de charge auxiliaire (14) assurant le transfert des charges en volume, qui est positionné parallèlement au registre de lecture (4) et qui comporte des moyens d'injection dans tous ses étages d'une deuxième charge d'entraînement ($Q_2$) et des grilles (15) permettant le transfert de ces deuxièmes charges d'entraînement dans le registre de lecture.

13. Dispositif selon l'une des revendications 10 ou 11, caractérisé en ce qu'il comporte un registre à décalages à transfert de charge auxiliaire (14), assurant le transfert des charges en volume, qui comporte des moyens d'injection dans tous ses étages d'une deuxième charge d'entraînement ($Q_2$) et des moyens permettant le transfert de ces deuxièmes charges d'entraînement dans les diodes d'entrée (5) de la mémoire (4).

14. Dispositif selon l'une des revendications 12 ou 13, caractérisé en ce que la première ($Q_1$) et la deuxième ($Q_2$) charges d'entraînement sont égales.

## Claims

1. A photosensitive line transfer device comprising a photosensitive zone (1) having M lines of N photosensitive points, the photosensitive points of the different lines being connected in parallel by column conductors (C$_1$...C$_N$) to diodes (5) belonging to a line memory which ensures at least the transfer of the signal charges (Q$_S$) of one line to a read register (7), this photosensitive device comprising feedback amplifiers (6) the input of which is connected to a column and to a diode (5) of the memory and the output of which is connected to a transfer gate (P) of the memory adjacent to one of the diodes, characterized in that :

— the line memory (4) and the read register (7) are realized in such a way that the transfer of the charges is a volume transfer ;

— means are provided for adjusting the threshold voltage (V$_{T1}$) of each amplifier (6) in such a way that the point of operation (P$_{OV}$) of the unit constituted by each amplifier (6), the diode (5) and the gate (P) of the memory (4) to which it is connected are located in the elevated gain zone (HB) of the transfer characteristic of the amplifier.

2. A device according to claim 1, characterized in that each amplifier (6) is constituted by a first and a second MOS transistor (T$_1$, T$_2$) assembled as an inverter.

3. A device according to claim 2, characterized in that it comprises a first MOS transistor (T$_1$) of the enrichment type the gate of which constitutes the amplifier input while one of the other electrodes is connected to a constant biassing voltage (V$_{SS}$), and the last electrode of which constitutes the output of the amplifier and is connected to an electrode of the second MOS transistor (T$_2$).

4. A device according to claim 3, characterized in that it comprises a second MOS transistor (T$_2$) of the depletion type, the gate of which is connected to the output of the amplifier, while one other electrode is connected to a constant biassing voltage (V$_{DD}$).

5. A device according to claim 3, characterized in that it comprises a second MOS transistor (T$_2$) of the enrichment type, the gate of which is connected to one of its electrodes receiving a constant biassing voltage (V$_{DD}$).

6. A device according to one of claims 2 to 5, characterized in that the means allowing the threshold voltage of each amplifier (6) to be adjusted are constituted by an enrichment (11) of its own impurity type in the zone of the substrate (12) situated beneath the gate of the first MOS transistor (T$_1$).

7. A device according to one of claims 2 to 6, characterized in that the means allowing the threshold voltage of each amplifier (6) to be adjusted are constituted by a follower stage comprising a third and a fourth MOS transistor (T$_3$, T$_4$) inserted between each diode (5) of the memory (4) and the input of an amplifier (6), the threshold voltage of each amplifier being adjusted through the threshold voltage (V$_{T3}$) of the third MOS transistor, the gate of which is connected to a diode of the memory.

8. A device according to one of claims 2 to 7, characterized in that the means allowing the threshold voltage of each amplifier (6) to be adjusted are constituted by the realization of a first MOS transistor (T$_1$) of the channel P-depletion type and of a second MOS transistor (T$_2$) of the channel N-depletion type.

9. A device according to one of claims 1 to 8, characterized in that under each transfer gate (P) of the memory (4) adjacent to an input diode (5), there is provided a zone (13) of an impurity type opposed to that of the embedded channel (TV) situated under this gate.

10. A device according to one of claims 1 to 9, characterized in that the line memory (4) is constituted by a series of storage gates (C$_1$) adjacent to the transfer gates (P) of the memory and connected to the amplifiers (6), each storage gate (C$_1$) being connected to two transfer gates (C$_2$, C$_3$), one of them leading to a charge evacuation drain (D) and the other to the read register (7).

11. A device according to claim 10, characterized in that the read register (7) is a charge transfer shift register which is located parallelly to the line memory (4) and which comprises means for injecting a first driver charge (Q$_1$) into all of its stages.

12. A device according to one of claims 10 or 11, characterized in that it includes an auxiliary charge transfer shift register (14) ensuring the volume transfer of the charges and being positioned parallelly to the read register (7) and comprising means for injecting a second driver charge (Q$_2$) into all of its stages, and gates (15) allowing these second driver charges to be transferred into the read register.

13. A device according to one of claims 10 or 11, characterized in that it comprises an auxiliary charge transfer shift register (14) ensuring the volume transfer of the charges and including means for injecting a second driver charge (Q$_2$) into all of its stages, and comprising means allowing these second driver charges to be transferred into the input diodes (5) of the memory (4).

14. A device according to one of claims 12 or 13, characterized in that the first and the second driver charges (Q$_1$, Q$_2$) are equal.

**Patentansprüche**

1. Lichtempfindliche Zeilentransfervorrichtung mit einer lichtempfindlichen Zone (1) bestehend aus M Zeilen von je N lichtempfindlichen Punkten, wobei die lichtempfindlichen Punkte der verschiedenen Zeilen parallel über Spaltenleiter (C$_1$...C$_N$) an Dioden (5) angeschlossen sind, die zu einem Zeilenspeicher gehören, welcher zumindest die Übertragung der Signalladungen (Q$_S$) einer Zeile in ein Leseregister (7) bewirkt, wobei die lichtempfindliche Vorrichtung Gegenkopplungsverstärker (6) aufweist, deren Eingang an eine Spalte und an eine Diode (5) des Speichers und deren Ausgang an ein neben einer der Dioden liegendes Transfergate (P) des Speichers angeschlossen ist, dadurch gekennzeichnet, daß

— der Zeilenspeicher (4) und das Leseregister (7) so ausgebildet sind, daß der Ladungstransfer als Volumentransfer erfolgt ;

— Mittel die Festlegung der Schwellspannung ($V_{T1}$) jedes Verstärkers (6) so erlauben, daß der Arbeitspunkt ($P_{OV}$), der aus jedem Verstärker (6), der zugeordneten Diode (5) und dem zugeordneten Gate (P) des Speichers (4) gebildeten Einheit in dem Bereich (HB) hohen Verstärkungsgrads der Transferkennlinie des Verstärkers liegt.

2. Vorrichtung nach Anspruch 1, dadurch gekennzeichnet, daß jeder Verstärker (6) von einem ersten ($T_1$) und einem zweiten MOS-Transistor ($T_2$) gebildet wird, die als Inverter geschaltet sind.

3. Vorrichtung nach Anspruch 2, dadurch gekennzeichnet, daß sie einen ersten MOS-Transistor ($T_1$) vom Anreicherungstyp aufweist, dessen Gateelektrode den Eingang des Verstärkers bildet und von dem eine der beiden anderen Elektroden an eine konstante Vorspannung ($V_{SS}$) angeschlossen ist, während die letzte Elektrode den Ausgang des Verstärkers bildet und an eine Elektrode des zweiten MOS-Transistors ($T_2$) angeschlossen ist.

4. Vorrichtung nach Anspruch 3, dadurch gekennzeichnet, daß sie einen zweiten MOS-Transistor ($T_2$) vom Abreicherungstyp besitzt, dessen Gateelektrode an den Ausgang des Verstärkers angeschlossen ist und von dem eine der übrigen Elektroden an eine konstante Vorspannung ($V_{DD}$) angeschlossen ist.

5. Vorrichtung nach Anspruch 3, dadurch gekennzeichnet, daß sie einen zweiten MOS-Transistor ($T_2$) vom Anreicherungstyp besitzt dessen Gateelektrode an eine seiner Elektroden angeschlossen ist, die eine konstante Vorspannung ($V_{DD}$) zugeführt erhält.

6. Vorrichtung nach einem der Ansprüche 2 bis 5, dadurch gekennzeichnet, daß die Mittel, die die Festlegung der Schwellspannung jedes Verstärkers (6) erlauben, von einer Anreicherung (11) seines eigenen Verunreinigungstyps in der unter dem Gate des ersten MOS-Transistors ($T_1$) liegenden Zone des Substrats (12) gebildet werden.

7. Vorrichtung nach einem der Ansprüche 2 bis 6, dadurch gekennzeichnet, daß die Mittel, die die Festlegung der Schwellspannung jedes Verstärkers (6) erlauben, von einer Folgestufe gebildet werden, die einen dritten und einen vierten MOS-Transistor ($T_3$, $T_4$) aufweist, die zwischen jeder Diode (5) des Speichers (4) und den Eingang eines Verstärkers (6) eingefügt sind, wobei die Schwellspannung jedes Verstärkers über die Schwellspannung ($V_{T3}$) des dritten MOS-Transistors eingestellt wird, dessen Gate an eine Diode des Speichers angeschlossen ist.

8. Vorrichtung nach einem der Ansprüche 2 bis 7, dadurch gekennzeichnet, daß die Mittel zur Einstellung der Schwellspannung jedes Verstärkers (6) durch die Ausbildung eines ersten MOS-Transistors ($T_1$) vom Kanal-P-Abreicherungstyp und einen zweiten MOS-Transistor ($T_2$) vom Kanal-N-Abreicherungstyp gebildet werden.

9. Vorrichtung nach einem der Ansprüche 1 bis 8, dadurch gekennzeichnet, daß unter jedem Transfergate (P) des Speichers (4) neben einer Eingangsdiode (5) eine Zone (13) eines Verunreinigungstyps entgegengesetzt zu dem des unter diesem Gate liegenden eingebetteten Kanals (TV) liegt.

10. Vorrichtung nach einem der Ansprüche 1 bis 9, dadurch gekennzeichnet, daß der Zeilenspeicher (4) aus einer Reihe von Speichergates ($C_1$) besteht, die den an die Verstärker (6) angeschlossenen Transfergates (P) des Speichers benachbart sind, wobei jedes Speichergate ($C_1$) in zwei Transfergates ($C_2$, $C_3$) mündet, von denen das eine zu einem Ladungsableitungsdrain (D) und das andere zum Leseregister (7) führt.

11. Vorrichtung nach Anspruch 10, dadurch gekennzeichnet, daß das Leseregister (7) ein Ladungstransferschieberegister ist, das parallel zum Zeilenspeicher (4) angeordnet ist und Mittel zur Injektion einer ersten Treiberladung ($Q_1$) in alle seine Stufen enthält.

12. Vorrichtung nach einem der Ansprüche 10 oder 11, dadurch gekennzeichnet, daß ein Ladungstransfer-Hilfsschieberegister (14), das den Volumentransfer der Ladungen bewirkt, zum Leseregister (7) parellel angeordnet ist und Mittel zur Injektion einer zweiten Treiberladung ($Q_2$) in alle seine Stufen aufweist, sowie Gates (15) vorgesehen sind, die den Transfer dieser zweiten Treiberladungen in das Leseregister erlauben.

13. Vorrichtung nach einem der Ansprüche 10 oder 11, dadurch gekennzeichnet, daß ein Ladungstransfer-Hilfsschieberegister (14), das den Volumentransfer der Ladungen bewirkt und Mittel zum Einspeisen einer zweiten Treiberladung ($Q_2$) in alle seine Stufen aufweist, sowie Mittel vorgesehen sind, mit denen der Transfer dieser zweiten Treiberladungen in die Eingangsdioden (5) des Speichers (4) ermöglicht wird.

14. Vorrichtung nach einem der Ansprüche 12 oder 13, dadurch gekennzeichnet, daß die beiden Treiberladungen ($Q_1$, $Q_2$) gleich groß sind.

# FIG_1

# FIG_2

FIG_3

FIG_4

FIG_5

FIG_6

$V_{DD}$

$T_2$

$T_3$

$T_1$

$T_4$

$V_{SS}$

FIG_7

$V_{DD}$

$T_2$　$T_1$　$C_i$　P

5

N

P

FIG_8

Intensité

$10^{-6}$

14

$10^{-7}$

16

$10^{-8}$

1k　10k　100k　1M

f

FIG_9

1

15

0

250k　500k　1M

f

FIG_10-a

FIG_10-b

FIG_10-c

FIG_10-d

FIG_10-e

FIG_10-f

FIG_10-g

FIG_11